**Europäisches Patentamt**

**European Patent Office**

**Office européen des brevets**

(11) Veröffentlichungsnummer: **0 220 454**
**B1**

# EUROPÄISCHE PATENTSCHRIFT

(45) Veröffentlichungstag der Patentschrift:
05.09.90

(51) Int. Cl.⁵: **H03K 17/14**

(21) Anmeldenummer: **86112707.4**

(22) Anmeldetag: **15.09.86**

(54) Schaltungsanordnung zur Kompensation des Temperaturganges von Gatterlaufzeiten.

(30) Priorität: **27.09.85 DE 3534561**

(43) Veröffentlichungstag der Anmeldung:
**06.05.87 Patentblatt 87/19**

(45) Bekanntmachung des Hinweises auf die Patenterteilung:
**05.09.90 Patentblatt 90/36**

(84) Benannte Vertragsstaaten:
**AT DE FR GB IT NL**

(56) Entgegenhaltungen:
**EP-A- 0 012 839**
**FR-A- 2 354 001**
**FR-A- 2 519 211**
**US-A- 3 515 998**
**US-A- 3 746 890**
**US-A- 3 769 528**

**PATENTS ABSTRACTS OF JAPAN, Band 8,**
**Nr. 139 (E-253)[1576], 28. Juni 1984; &**
**JP-A-59 47 842 (NIPPON DENKI K.K.) 17-03-1984**
**IEEE JOURNAL OF SOLID-STATE CIRCUITS, Band**
**SC-10, Nr. 6, Dezember 1975, Seiten 524-529, New York,**
**US; T. SUDO et al.: "A monolithic 8 pJ/2 GHz logic**
**family"**

(73) Patentinhaber: **Siemens Aktiengesellschaft,**
**Wittelsbacherplatz 2, D-8000 München 2(DE)**

(72) Erfinder: **Wilhelm, Wilhelm, Dr., Geigenbergerstrasse 23,**
**D-8000 München 71(DE)**
Erfinder: **Sehrig, Peter, Berchemstrasse 41,**
**D-8000 München 21(DE)**

**Beschreibung**

Die Erfindung betrifft eine Schaltungsanordnung nach dem Oberbegriff des Patentanspruchs 1.

Signallaufzeiten in integrierten Schaltkreisen besitzen einen positiven Temperaturgang, d.h. mit steigender Temperatur vergrößern sich die Laufzeiten aufgrund der Erhöhung der Chip-Temperatur. Diese Eigenschaft bezieht sich auf alle Funktionselemente einer integrierten Schaltung, z.B. Gatter, Verstärker und Flip-Flops. Die positiven Temperaturgänge werden hervorgerufen durch die positiven Temperaturgänge der Bahnwiderstände, der Sperrschichtkapazitäten mit der daraus resultierenden Vergrößerung der RC-Zeitkonstanten und der Transitzeit. Die Laufzeitzunahme pro Gatter beträgt im unteren Temperaturbereich zwischen etwa 0 und 70°C etwa 0,2 %/K und steigt bei über 100°C auf ca. 0,5 %/K.

Schaltungen werden deshalb üblicherweise so dimensioniert, daß bei zunehmender Temperatur auftretende Phasengänge und Laufzeitunterschiede von Signalen noch tolerierbar sind. Als Alternative werden die Signalwege mit zusätzlichen Gattern so angepaßt, daß gleiche Laufzeiten und gleiche Phasengänge auftreten. Eine Kompensation des positiven Temperaturgangs kann damit nicht durchgeführt werden.

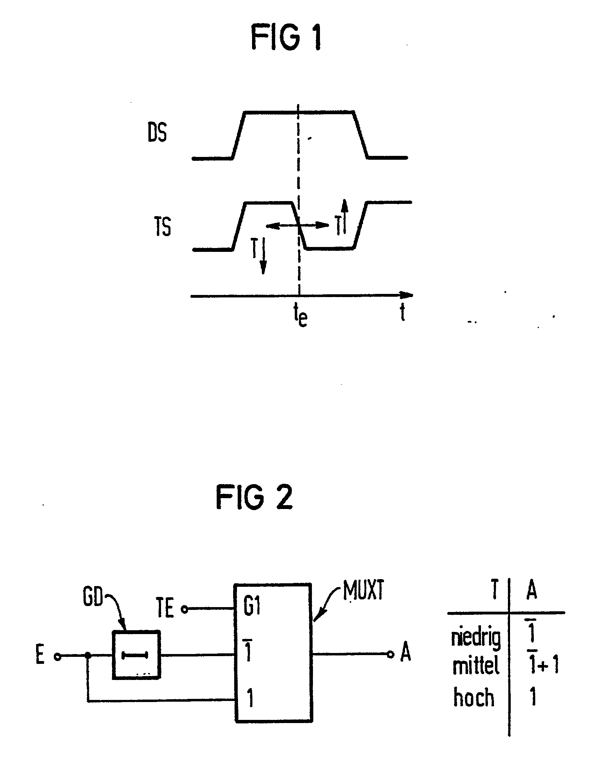

Am Beispiel eines Entscheiderbausteins zeigt Fig. 1 Signaldiagramme und den Temperatureinfluß auf eine vom Taktsignal zu treffende Zeitentscheidung. Aus dem Datensignal DS am Dateneingang des Entscheiderbausteins wird über in- und externe Schaltungen der Takt rückgewonnen. Über die Taktrückgewinnung, Filter und Verstärker wird der Takt aufbereitet und auf den Takteingang eines Entscheider-Flip-Flops gegeben, an dessen Dateneingang das Datensignal DS liegt. Jede der in- und externen Schaltungen zur Taktrückgewinnung besitzt einen positiven Temperaturgang. Je größer der Temperaturgang des Taktsignalweges vom Dateneingang des Entscheiderbausteins zum Takteingang des Entscheider-Flip-Flops ist, desto stärker verändert sich der Entscheidungszeitpunkt gegenüber dem feststehendem Datensignal. Soll gemäß Fig. 1 der Entscheidungszeitpunkt $t_e$ durch die abfallende Flanke des Taktsignals TS gegeben sein, so verschiebt sich dieser Zeitpunkt bei niedrigeren Temperaturen gemäß der schnelleren Laufzeiten zu früheren Zeitpunkten, während er sich bei höheren Temperaturen aufgrund der höheren Laufzeit des rückgewonnenen Taktsignals TS zu späteren Zeitpunkten verschiebt.

Zusätzliche, vor den Dateneingang des Entscheider-Flip-Flops geschaltete Gatter mit gleicher Laufzeit und gleichem Temperaturgang wie die für die Taktrückgewinnung und -aufbereitung erforderlichen Schaltungen besitzen den Nachteil eines hohen schaltungstechnischen Aufwands.

Der Erfindung liegt die Aufgabe zugrunde, eine Schaltungsanordnung mit negativem Temperaturgang zur Kompensation des Temperaturgangs von Gatterlaufzeiten anzugeben.

Diese Aufgabe wird bei einer Schaltungsanordnung der eingangs genannten Art erfindungsgemäß durch die Merkmale des kennzeichnenden Teils des Patentanspruchs 1 gelöst.

Weitere Ausgestaltungen des Erfindungsgedankens sind in Unteransprüchen gekennzeichnet.

Die Erfindung wird im folgenden anhand von in den Figuren der Zeichnung dargestellten Ausführungsbeispielen näher erläutert. Es zeigt:

Fig. 2 ein schematisches Schaltbild einer erfindungsgemäßen Schaltung und

Fig. 3 ein Schaltbild einer konkreten Ausführungsform einer Schaltung nach Fig. 2.

Gemäß Fig. 2 enthält die erfindungsgemäße Schaltungsanordnung einen temperaturgesteuerten Multiplexer MUXT und ein Verzögerungsgatter GD. Der temperaturgesteuerte Multiplexer MUXT wird über ein Temperatursignal am Steuereingang TE gesteuert. Das zu verarbeitende Signal liegt am Signaleingang E der Schaltungsanordnung, der direkt mit dem einer logischen 1 des Steuereingangs TE entsprechenden Eingang des Multiplexers und über das Verzögerungsgatter DG mit dem einer logischen 0 des Steuereingangs TE entsprechenden Eingang des temperaturgesteuerten Multiplexers MUXT verbunden ist. Den Ausgang A der erfindungsgemäßen Schaltungsanordnung bildet der Ausgang des Multiplexers.

Erfindungsgemäß wird nun das zu verarbeitende Signal aufgeteilt und sowohl verzögert als auch unverzögert den Eingängen des temperaturgesteuerten Multiplexers MUXT zugeführt. Der Multiplexer arbeitet derart, daß bei tiefen Temperaturen die Laufzeit künstlich verzögert wird und das verzögerte Signal zum Ausgang geschaltet wird. Bei hohen Temperaturen wird dagegen das unverzögerte Signal zum Ausgang geschaltet. Im Übergangsbereich bzw. im mittleren Temperaturbereich wird das verzögerte mit dem unverzögerten Signal gemischt und zum Ausgang A geschaltet. Diese Funktionsweise wird anhand der zu Fig. 2 gehörenden Funktionstabelle dargestellt, die in Abhängigkeit von der Temperatur T den jeweils zum Ausgang A geschalteten Eingang des Multiplexers MUXT angibt.

Die Umschaltung des temperaturgesteuerten Multiplexers MUXT ist derart linearisiert, daß sie über dem gesamten Betriebstemperaturbereich erfolgt. Da in diesem Bereich auch der Übergangsbereich liegt, in dem das unverzögerte und das verzögerte Signal gemischt werden, können unterhalb 500 MHz nur sinusförmige Signale verarbeitet werden, oberhalb dieser Frequenz dagegen auch Impulse. Somit ergibt sich der negative Temperaturgang dadurch, daß bei normal schnellen Gatterlaufzeiten das verzögerte Signal und bei größeren Gatterlaufzeiten das unverzögerte Signal zum Ausgang A des Multiplexers MUXT gelegt wird. Im Beispiel nach Fig. 1 kann eine erfindungsgemäße Schaltungsanordnung deshalb im Taktweg für die Rückgewinnung und Aufbereitung des Takt liegen.

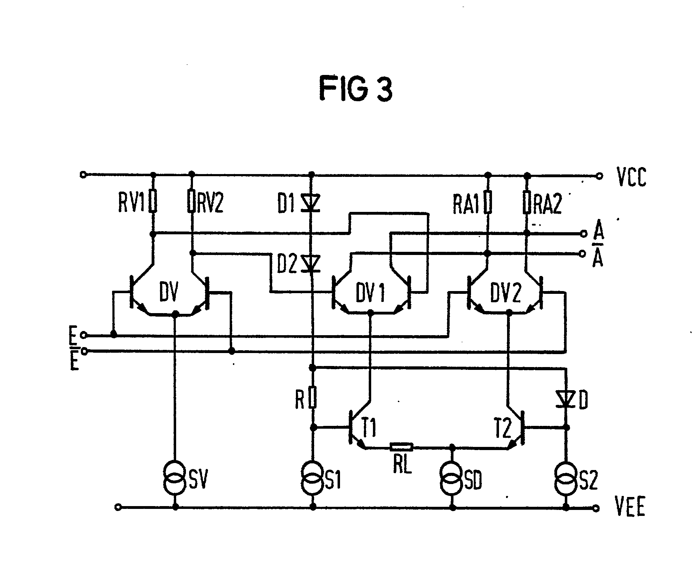

Fig. 3 stellt eine konkrete Ausführungsform einer Schaltung nach Fig. 2 dar. Die Schaltung ist in ECL-Technik ausgeführt und wird an die Pole VCC und VEE einer Versorgungsspannungsquelle angeschlossen. Das zu verarbeitende Signal liegt in komplementärer Form, d.h. invertiert und nicht invertiert an dem Signaleingängen E und $\bar{E}$. Die beiden Signaleingänge sind parallel mit den Eingängen zweier Differenzverstärker DV und DV2 verbunden. Die Kollektoren der den Differenzverstärker DV bildenden Transistoren sind über die beiden Lastwiderstände RV1 und RV2 mit dem positiven Pol der Versorgungsspannungquelle VCC verbunden. Die beiden Ausgänge des Differenzverstärkers DV sind auf die Eingänge eines nachfolgenden Differenzverstärkers DV1 geführt.

Die jeweiligen Ausgänge der beiden Differenzverstärker DV1 und DV2 sind parallel geschaltet und über die beiden Lastwiderstände RA1 und RA2 mit dem positiven Pol VCC der Versorgungsspannungsquelle verbunden. Gleichzeitig bilden die Kollektoren der invertierten Signaleingängen zugeordneten Transistoren der Differenzverstärker DV1 und DV2 den Signalausgang A, während die mit dem Lastwiderstand RA1 verbundenen Kollektoren der jeweils zugeordneten Transistoren der Differenzverstärker DV1 und DV2 den invertierten Signalausgang $\bar{A}$ bilden. Dabei ist der mit dem nichtinvertierten Ausgang A verbundene Transistor des Differenzverstärkers DV1 vom Ausgang des am nichtinvertierten Signaleingang E liegenden Transistors des Differenzverstärkers DV gesteuert.

Die Emitter der drei Differenzverstärker DV, DV1 und DV2 sind jeweils direkt miteinander verbunden. Die Emitter des Differenzverstärkers DV liegen über eine Stromquelle SV am negativen Pol VEE der Versorgungsspannungsquelle. Die Emitter des Differenzverstärkers DV1 sind an den Kollektor eines Transistors T1 und die Emitter des Differenzverstärkers DV2 an den Kollektor eines Transistors T2 angeschlossen. Die beiden Transistoren T1 und T2 bilden einen weiteren Differenzverstärker, deren Emitter über eine Stromquelle SD am negativen Pol VEE der Versorgungsspannungsquelle liegen. Gemäß Fig. 3 ist zwischen dem Emitter des Transistors T1 und die Stromquelle SD ein Widerstand RL angeordnet.

Zwischen die Pole VCC und VEE der Versorgungsspannugnsquelle ist die Reihenschaltung zweier Dioden D1 und D2, eines Widerstandes R und einer Stromquelle S1 geschaltet. Die Basis des Transistors T1 ist mit dem Verbindungspunkt des Widerstandes R mit der Stromquelle S1 verbunden. Vom Verbindungspunkt des Widerstandes R mit der Diode D2 führt die Reihenschaltung einer Diode D und einer Stromquelle S2 zum Pol VEE der Versorgungsspannungsquelle. Die Basis des Transistors T2 ist an den Verbindungspunkt der Diode D mit der Stromquelle S2 angeschlossen. Die Stromquellen SV, S1, S2 und SD werden üblicherweise durch die Ausgangskreise von Transistoren mit oder ohne Emitterwiderstand gebildet, deren Basen von einer Spannung, vorzugsweise einer gemeinsamen Basisspannung gesteuert werden.

Das aus dem Differenzverstärker DV gebildete Gatter dient zur Signalverzögerung. Die Änderung der Verzögerungszeit kann mit Hilfe der Lastwiderstände RV1 und RV2 vorgenommen werden. Das verzögerte Signal gelangt auf den Eingang des Differenzverstärkers DV1, der mit dem Transistor T1 ein UND-Gatter bildet. Das unverzögerte Signal gelangt außer zum Verzögerungsgatter zum Differenzverstärker DV2, der mit dem Transistor T2 ein UND-Gatter darstellt. Beide mit Seriesgating realisierte UND-Gatter werden über eine ODER-Verknüpfung in Form der jeweiligen Parallelschaltung der Ausgänge zum Ausgang gelegt.

Die thermische Umschaltung des Multiplexers wird mit Hilfe der entgegengesetzten Spannungstemperaturgänge des Widerstandes R und der Diode D erreicht. Bei niedrigen Temperaturen ist der Spannungsabfall über dem Widerstand R klein und die Schwellenspannung für die Diode relativ groß, so daß im wesentlichen der Transistor T1 leitet und damit das verzögerte Signal zum Ausgang A bzw. $\bar{A}$ geschaltet wird. Aufgrund des positiven Temperaturkoeffizienten des Widerstands R wird der Spannungsabfall über dem Widerstand mit zunehmender Temperatur größer, während gleichzeitig die Schwellenspannung der Diode D aufgrund ihres negativen Temperaturkoeffizienten absinkt. Damit wird zunehmend vom Transistor T1 auf den Transistor T2 umgeschaltet und das unverzögerte Eingangssignal gelangt über den Differenzverstärker DV2 zum Ausgang. Die Übergangskennlinie für den Umschaltbereich wird dabei mit Hilfe eines Widerstandes RL linearisiert, um einen möglichst großen Temperaturbereich für die Umschaltung zu erhalten.

Die Dioden D1 und D2 dienen zur Spannungspegelanpassung der durch die Transistoren T1 und T2 gebildeten Seriesgating Stufe an die potentialmäßig höher liegende, durch die Differenzverstärker DV, DV1 und DV2 dargestellte Seriesgating-Stufe.

## Patentansprüche

1. Schaltungsanordnung zur Kompensation des Temperaturgangs von Gatterlaufzeiten mit einem Signaleingang (E; E, $\bar{E}$) zur Einspeisung eines Eingangssignals und einem Signalausgang (A; A, $\bar{A}$), einem Verzögerungsgatter (GD; DV, SV, RV1, RV2) und einem Multiplexer (MUXT; T1, T2, DV1, DV2), **dadurch gekennzeichnet**, daß ein Eingang des Multiplexers (MUXT; T1, T2, DV1, DV2) direkt, ein anderer über das Verzögerungsgatter (GD; DV, SV, RV1, RV2) mit dem Signaleingang (E; E, $\bar{E}$) und der Ausgang des Multiplexers (MUXT) mit dem Signalausgang (A; A, $\bar{A}$) verbunden ist, wobei die Steuerung des Multiplexers (MUXT; T1, T2, DV1, DV2) temperaturabhängig so erfolgt, daß das Eingangssignal im unteren Temperaturbereich verzögert, im oberen Temperaturbereich unverzögert und im dazwischenliegenden Temperaturbereich gemischt sowohl verzögert als auch unverzögert zum Signalausgang (A; A, $\bar{A}$) gelangt.

2. Schaltungsanordnung nach Anspruch 1, **dadurch gekennzeichnet**, daß der temperaturgesteuerte Multiplexer (MUXT) aus zwei mit ihren jeweiligen Ausgangskreisen parallel geschalteteten Differenzverstärkern (DV1, DV2) gebildet wird, die in je einen Ausgangskreis einer weiteren Differenzverstärkerstufe (T1, T2) geschaltet sind, deren Eingänge von je einer Spannung mit entgegengesetztem Temperaturgang gesteuert werden.

3. Schaltungsanordnung nach Anspruch 2, **da-**

durch gekennzeichnet, daß die Eingänge der weiteren Differenzverstärkerstufe (T1, T2) über einen Widerstand (R) und eine Diode (D) gesteuert werden.

4. Schaltungsanordnung nach Anspruch 2 bis 3, dadurch gekennzeichnet, daß die Eingänge der weiteren Differenzverstärkerstufe (T1, T2) am Verbindungspunkt der Reihenschaltung eines Widerstandes (R) und einer Stromquelle (S1) sowie einer Diode (D) und einer Stromquelle (S2) liegen, die parallel mit einer Spannungsquelle (VCC, VEE) verbunden sind.

5. Schaltungsanordnung nach Anspruch 2 bis 4, dadurch gekennzeichnet, daß die Differenzverstärker (D1, D2) emittergekoppelt sind und in den Kollektorkreisen der weiteren Differenzverstärkerstufe (T1, T2) liegen, deren Emitter miteinander und mit einer Stromquelle (SD) verbunden sind.

6. Schaltungsanordnung nach Anspruch 5, dadurch gekennzeichnet, daß ein Emitter der weiteren Differenzverstärkerstufe (T1, T2) direkt, der andere über einen Widerstand (RL) mit der Stromquelle (SD) verbunden ist.

7. Schaltungsanordnung nach Anspruch 1 bis 6, dadurch gekennzeichnet, daß ein zusätzlicher Differenzverstärker (DV) mit Lastwiderständen (RV1, RV2) in den Ausgangskreisen das Verzögerungsgatter (GD) bildet.

8. Schaltungsanordnung nach Anspruch 7, dadurch gekennzeichnet, daß die Eingänge des zusätzlichen Differenzverstärkers (DV) und des im Ausgangskreis des von der Diode (D) gesteuerten Transistors (T2) der weiteren Differenzverstärkerstufe (T1, T2) liegenden Differenzverstärkers (DV2) mit komplementären Signaleingängen (E, Ē) verbunden sind und die Eingänge des im Ausgangskreis des von dem Widerstand (R) gesteuerten Transistors (T1) der weiteren Differenzverstärkerstufe (T1, T2) liegenden Differenzverstärkers (DV1) von den Ausgängen des zusätzlichen Differenzverstärkers (DV) gesteuert werden.

9. Schaltungsanordnung nach Anspruch 2 bis 8, dadurch gekennzeichnet, daß die Ausgänge der zwei mit ihren jeweiligen Ausgangskreisen parallel geschalteten Differenzverstärker (DV1, DV2) komplementäre Signalausgänge (A, Ā) bilden.

10. Schaltungsanordnung nach Anspruch 1 bis 9, dadurch gekennzeichnet, daß der temperaturgesteuerte Multiplexer (MUXT) aus Seriesgating-Gattern in emittergekoppelter Logik gebildet wird und eine Potentialanpassung der Gatter über Dioden (D1, D2) erfolgt.

## Claims

1. Circuit arrangement for compensating the temperature dependence of gate propagation times, having a signal input (E; E, Ē) for feeding in an input signal and a signal output (A; A, Ā), a delay gate (GD; DV, SV, RV1, RV2) and a multiplexer (MUXT; T1, T2, DV1, DV2), characterized in that an input of the multiplexer (MUXT; T1, T2, DV1, DV2) is connected directly and another is connected via the delay gate (GD; DV, SV, RV1, RV2) to the signal input

(E; E, Ē) and the output of the multiplexer (MUXT) is connected to the signal output (A; A, Ā), the control of the multiplexer (MUXT; T1, T2, DV1, DV2) occurring in dependence on temperature in such a way that the input signal arrives at said signal output (A; A, Ā) delayed in the lower temperature range, undelayed in the upper temperature range and mixed, both delayed and also undelayed, in the temperature range lying between said ranges.

2. Circuit arrangement according to Claim 1, characterized in that the temperature-controlled multiplexer (MUXT) is formed from two differential amplifiers (DV1, DV2) connected in parallel to their respective output circuits, said differential amplifiers being connected to in each case one output circuit of a further differential amplifier stage (T1, T2), the inputs of which are controlled in each case by a voltage with opposite temperature dependence.

3. Circuit arrangement according to Claim 2, characterized in that the inputs of the further differential amplifier stage (T1, T2) are controlled via a resistor (R) and a diode (D).

4. Circuit arrangement according to Claim 2 to 3, characterized in that the inputs of the further differential amplifier stage (T1, T2) are located at the junction point of the series circuit of a resistor (R) and a current source (S1) and of a diode (D) and a current source (S2) which are connected in parallel to a voltage source (VCC, VEE).

5. Circuit arrangement according to Claim 2 to 4, characterized in that the emitters of the differential amplifiers (D1, D2) are coupled together and connected into the collector circuits of the further differential amplifier stage (T1, T2), the emitters of which are connected to one another and to a current source (SD).

6. Circuit arrangement according to Claim 5, characterized in that an emitter of the further differential amplifier stage (T1, T2) is connected directly and the other via a resistor (RL) to the current source (SD).

7. Circuit arrangement according to Claim 1 to 6, characterized in that an additional differential amplifier (DV) having load resistors (RV1, RV2) in the output circuits forms the delay gate (GD).

8. Circuit arrangement according to Claim 7, characterized in that the inputs of the additional differential amplifier (DV) and of the differential amplifier (DV2) located in the output circuit of the transistor (T2), controlled by the diode (D), of the further differential amplifier stage (T1, T2) are connected to complementary signal inputs (E, Ē) and the inputs of the differential amplifier (DV1) located in the output circuit of the transistor (T1), controlled by the resistor (R), of the further differential amplifier stage (T1, T2) are controlled by the outputs of the additional differential amplifier (DV).

9. Circuit arrangement according to Claim 2 to 8, characterized in that the outputs of the two differential amplifiers (DV1, DV2) connected in parallel to their respective output circuits form complementary signal outputs (A, Ā).

10. Circuit arrangement according to Claim 1 to 9, characterized in that the temperature-controlled multiplexer (MUXT) is formed from series-gating gates in emitter-coupled logic and potential matching of the gates occurs via diodes (D1, D2).

**Revendications**

1. Montage pour compenser l'allure en température de temps de propagation dans des portes, comportant une entrée (E; E, Ē), pour l'introduction d'un signal d'entrée, et une sortie (A; A, Ā) pour le signal, une porte de retardement (GD; DV, SV, RV1, PV2) et un multiplexeur (MUXT; T1, T2, DV1, DV2), caractérisé par le fait qu'une entrée du multiplexeur (MUXT; T1, T2, DV1, DV2) est reliée directement à l'entrée (E; E, Ē) du signal et une autre entrée du multiplexeur est reliée à cette entrée du signal par l'intermédiaire de la porte de retardement (GD; DV, SV, RV1, RV2), et la sortie du multiplexeur (MUXT) est reliée à la sortie (A; A, Ā) du signal, la commande du multiplexeur (MUXT; T1, T2, DV1, DV2) s'effectuant en fonction de la température de sorte que le signal d'entrée parvient à la sortie (A; A, Ā) du signal d'une manière retardée dans la plage inférieure de températures, sans retard dans la plage supérieure de températures et d'une manière mélangée en étant à la fois retardé et non retardé dans la plage intermédiaire de températures.

2. Montage suivant la revendication 1, caractérisé par le fait que le multiplexeur (MUXT) commandé en fonction de la température, est formé de deux amplificateurs différentiels (DV1, DV2), qui sont raccordés en parallèle au niveau de leurs circuits respectifs de sortie et sont branchés dans un circuit respectif de sortie d'un autre étage amplificateur différentiel (T1, T2), dont les entrées sont commandées par une tension respective possédant une allure en température opposée.

3. Montage suivant la revendication 2, caractérisé par le fait que les entrées de l'autre étage du capteur différentiel (T1, T2) sont commandées par l'intermédiaire d'une résistance (R) et d'une diode (D).

4. Montage suivant les revendications 2, 3, caractérisé par le fait que les entrées de l'autre étage amplificateur différentiel (T1, T2) sont raccordées au point de jonction du circuit série formé d'une résistance (R) et d'une source de courant (S1) ainsi que d'une diode (D) et d'une source de courant (S2), qui sont reliées en parallèle à une source de tension (VCC, VEE).

5. Montage suivant les revendications 2 à 4, caractérisé par le fait que les amplificateurs différentiels (D1, D2) sont raccordés selon un couplage d'émetteurs et sont branchés dans les circuits de collecteur de l'autre étage amplificateur différentiel (T1, T2), dont les émetteurs sont reliés entre eux et à une source de courant (SD).

6. Montage suivant la revendication 5, caractérisé par le fait qu'un émetteur de l'autre étage amplificateur différentiel (T1, T2) est relié directement à la source de courant (SD), tandis que l'autre est relié à cette source par l'intermédiaire d'une résistance (RL).

7. Montage suivant l'une des revendications 1 à 6, caractérisé par le fait que l'amplificateur différentiel supplémentaire (DV) forme, avec les résis-

tances de charge (RV1, RV2) situées dans les circuits de sortie, la porte de retardement (GD).

8. Montage suivant la revendication 7, caractérisé par le fait que les entrées de l'amplificateur différentiel supplémentaire (DV) et de l'amplificateur différentiel (DV2), qui est situé dans le circuit de sortie du transistor (T2), commandé par la diode (D), de l'autre étage amplificateur différentiel (T1, T2), sont reliés à des entrées de signaux complémentaires (E, Ē) et que les entrées de l'amplificateur différentiel (DV1), qui est situé dans le circuit de sortie du transistor (T1), commandé par la résistance (R), de l'autre étage amplificateur différentiel (T1, T2), sont commandées par les sorties de l'amplificateur différentiel supplémentaire (DV).

9. Montage suivant les revendications 2 à 8, caractérisé par le fait que les sorties des deux amplificateurs différentiels (DV1, DV2), qui sont branchées en parallèle au niveau de leurs circuits respectifs de sortie, forment des sorties de signaux complémentaires (A, Ā).

10. Montage suivant les revendications 1 à 9, caractérisé par le fait que le multiplexeur (MUXT), qui est commandé en fonction de la température, est formé par des portes de transfert série selon une logique à émetteurs couplés et qu'une adaptation du potentiel des portes est réalisée au moyen de diodes (D1, D2).

# FIG 1

# FIG 2

| T | A |
|---|---|
| niedrig | $\overline{1}$ |
| mittel | $\overline{1}+1$ |
| hoch | 1 |

# FIG 3